(19) Europäisches Patentamt / European Patent Office / Office européen des brevets

(11) **EP 4 261 557 A1**

(12) **EUROPEAN PATENT APPLICATION**

(43) Date of publication:
**18.10.2023   Bulletin 2023/42**

(21) Application number: **22168641.3**

(22) Date of filing: **15.04.2022**

(51) International Patent Classification (IPC):
**G01R 33/48** (2006.01)     **G01R 33/54** (2006.01)
**G01R 33/561** (2006.01)     **G01R 33/44** (2006.01)
**G01R 33/485** (2006.01)     **G01R 33/565** (2006.01)

(52) Cooperative Patent Classification (CPC):
**G01R 33/4818; G01R 33/543; G01R 33/561;**
G01R 33/443; G01R 33/4828; G01R 33/485;
G01R 33/56545; G01R 33/56554

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventor: **EGGERS, Holger**
**Eindhoven (NL)**

(74) Representative: **Philips Intellectual Property & Standards**
**High Tech Campus 52**
**5656 AG Eindhoven (NL)**

(54) **MR IMAGING USING PARTIAL ECHO ACQUISITION**

(57)     The invention relates to a method of MR imaging of an object (10) placed in an examination volume of an MR system (1). It is an object of the invention to provide a method that enables improved MR imaging using partial echo acquisition. The method of the invention comprises the steps of: subjecting the object (10) to an imaging sequence comprising a series of RF excitations, wherein an echo signal is generated in the presence of a readout magnetic field gradient in each repetition time interval between successive RF excitations, wherein phase-encoding magnetic field gradients (P, S) are switched in each repetition time interval to sample a pre-defined region of k-space; acquiring the echo signals from the object (10) as partial echoes with different readout polarities, each echo signal being associated with either a first direction of the readout magnetic field gradient or a second direction of the readout magnetic field gradient which is opposite to the first direction, wherein the echo signals associated with the first and/or the second direction sample k-space sparsely in at least one phase-encoding direction (P, S); and reconstructing an MR image from the acquired echo signals. Furthermore, the invention proposes to apply a shift in k-space in the readout direction to the acquired echo signal data and to reconstruct an intermediate MR image for each of a number of different shift values, wherein a final MR image is computed from these intermediate MR images by selecting, for each voxel of the final MR image, the voxel value with the maximum intensity from the set of intermediate MR images at the respective voxel position. Signal loss caused by phase variations of the acquired partial echo signals can be avoided in this way. Moreover, the invention relates to an MR system (1) and to a computer program to be run on an MR system (1).

Fig. 2

EP 4 261 557 A1

## Description

FIELD OF THE INVENTION

The invention relates to the field of magnetic resonance (MR) imaging. It concerns a method of MR imaging of an object placed in the examination volume of an MR system. The invention also relates to an MR system and to a computer program to be run on an MR system.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

In MR imaging, fractional sampling of k-space along the readout (frequency-encoding) direction, herein referred to as partial echo (PE) acquisition, is a well-known strategy for reducing the echo time (TE), see M. Bydder et al. in NMR in Biomedicine, 2021; 34:e4458. This is useful for acquiring MR signals from short $T_2$ species but also reduces the repetition time (TR) and, if applicable, the inter-echo spacing of the used imaging sequence. PE sampling is of particular interest in magnetic resonance angiography (MRA) to mitigate signal loss induced by flow.

In theory, partial Fourier (PF) methods such as PE acquisition allow sampling only one half of k-space. The other half of k-space is synthesized in reconstruction under the assumption of conjugate symmetry, which only holds for real (as opposed to complex) MR signals in image space. Reconstruction by simple Fourier transform is not advisable from PE sampling. However, various algorithms have been developed to produce relatively artifact-free images based on the assumption that there is smooth phase variation across the images. In practice, the PE sampling is slightly extended to fully cover the central k-space region and thus to capture low-frequency phase variation.

PE methods are fundamentally limited by the missing k-space data, which prevent recovering the high-frequency phase variation and cause signal loss. Acceleration methods, such as parallel imaging (PI) and compressed sensing (CS), are in general unable to compensate for this deficiency, mainly due to the large size of the continuous k-space area spared by the incomplete sampling.

SUMMARY OF THE INVENTION

It is an object of the invention to provide a method that enables improved MR imaging using PE acquisition.

In accordance with the invention, a method of MR imaging of an object placed in an examination volume of an MR system is disclosed. The method comprises the following steps:

- subjecting the object to an imaging sequence comprising a series of RF excitations, wherein an echo signal is generated in the presence of a readout magnetic field gradient in each repetition time interval between successive RF excitations, wherein phase-encoding magnetic field gradients are switched in each repetition time interval to sample a pre-defined region of k-space;
- acquiring the echo signals from the object as partial echoes with different readout polarities, each echo signal being associated with either a first direction of the readout magnetic field gradient or a second direction of the readout magnetic field gradient which is opposite to the first direction, wherein the echo signals associated with the first and/or the second direction sample k-space sparsely in at least one phase-encoding direction; and
- reconstructing an MR image from the acquired echo signals.

The invention proposes to acquire PE readouts with two gradient polarities in opposite directions, i.e. a bipolar PE acquisition. Previously, two PE readouts with gradient polarities in opposite directions and identical phase encoding have been combined to obtain one (virtual) full echo (FE) readout. In this way, a complete sampling of k-space along the readout direction has been obtained, with the short TE of the PE acquisition, but only in almost twice the acquisition time, see M. B. Scheidegger et al. in Magnetic Resonance Imaging 1991; 9:517-524. The invention proposes that the PE readouts with positive and negative gradient polarity each sample k-space sparsely in at least one of the phase-encoding directions. Sparse sampling (also referred to as subsampling) means that the sampling density in the phase-encoding direction is lower than required by the Nyquist criterion according to the imaged field of view (FOV). The invention also proposes that the PE readouts with positive and negative polarity do not necessarily share the same phase encoding. Not the same phase encoding means that the PE readouts with positive and negative polarity do not only cover k-space differently along the readout direction, but also in at least one of the phase-encoding directions.

In an embodiment of the invention, the echo signals associated with the first readout direction sample a sub-region of k-space that is not sampled by the echo signals associated with the second readout direction, and vice versa. In other words, the k-space area that is spared by the echo signals associated with the first readout direction is covered by the echo signals associated with the second readout direction. The invention thus achieves a synthesis of the missing k-space data without the assumption that there is smooth phase variation across the image. For this purpose, the invention proposes to apply strategies known as such in the art for reconstructing artifact-free images from sparsely sampled k-space data, such as sensitivity encoding (SENSE), compressed sensing (CS), and combinations thereof, for the synthesis of the missing k-space data, instead of conventional PE strategies.

In a further embodiment, the k-space regions sampled by the echo signals associated with the first and second directions, respectively, overlap in a central part of k-space. In another embodiment, the echo signals associated with the first and second directions, taken in combination, sample k-space fully in a central part. In even another embodiment, they sample k-space in an interleaved pattern in the at least one phase-encoding direction. This results in a higher sampling density, or even full sampling, in the k-space center, but still without increasing TE or the overall acquisition time compared to conventional PE methods.

Reversing the readout direction during the acquisition causes distortions induced by main magnetic field inhomogeneity to change direction. These distortions can be addressed by adding the step of mapping the main magnetic field inhomogeneity, wherein the main magnetic field inhomogeneity is taken into account in the step of reconstructing the MR image. Alternatively, the distortions can be estimated from the two sparsely sampled individual data sets (one associated with the first readout direction, the other associated with the second readout direction), requiring a separate intermediate reconstruction of both and the application of a registration to the resulting intermediate MR images.

Similarly, reversing the readout direction during the acquisition potentially causes linear and higher order gradient fields to change. These changes can be addressed by mapping a spatially or spatiotemporally varying phase difference between the echo signals associated with the first and the second direction, respectively, wherein the phase difference is taken into account in the step of reconstructing the MR image. This phase difference can again be estimated from the two sparsely sampled individual data sets, requiring a separate intermediate reconstruction of both, or from separate measurements.

Moreover, reversing the readout gradient during the acquisition potentially alters the integral of the readout gradient from TR to TR. In a further embodiment, a spoiler magnetic field gradient in the readout direction, applied after acquiring the echo signals, is adapted in the imaging sequence such that this integral stays the same from TR to TR. In this way, a steady-state spoiling regime can be preserved, for example.

In non-contrast-enhanced cerebral MRA, a TE for which the MR signals from water and from fat have an opposed phase is often favored. However, this results in a low scan efficiency of the employed gradient-echo sequence, in particular at 1.5 T, while only providing a poor fat suppression. In a further embodiment, a TE is chosen for which the MR signals from water and from fat are approximately in quadrature, i.e. have a phase difference of $\pm 90°$, and a one-point Dixon method is applied, known as such in the art for separating MR signals from water and from fat from echo signals acquired at a single TE.

Using a two-point Dixon method, or dual-acquisition Dixon imaging, principally promises a better fat suppression and permits shortening the TE further, but usually involves introducing dead times to shift the readout magnetic field gradient for chemical shift encoding, which again negatively affects the scan efficiency. Hence, according to a further aspect, the invention proposes that the echo signals are acquired at different TEs, each echo signal being associated with either a first TE or a second TE so that a chemical shift encoding is applied to the acquired echo signals, wherein contributions from water and fat are then separated in the step of reconstructing the MR image according to a (as such known) two-point Dixon method. The invention thus proposes combining dual-acquisition Dixon imaging with bipolar PE acquisition. In this way, the invention allows enhancing image quality by shortening the TE, eliminating the fat signal, avoiding partial echo artifacts, and increasing the signal-to-noise ratio (SNR).

In order to improve the scan efficiency of the resulting gradient-echo imaging sequences, the strength of the readout magnetic field gradient applied during acquisition of the echo signals associated with the shorter of the two TEs can be made smaller than the strength of the readout magnetic field gradient applied during acquisition of the echo signals associated with the longer of the two TEs. Furthermore, the partial echo factor (PEF) can be adapted to maximize the acquisition time under the constraints imposed by the phase-encoding magnetic field gradients. Alternatively or additionally, the spoiler readout magnetic field gradient with the larger area is associated with the shorter TE. That is, the area of the spoiler readout magnetic field gradient associated with the shorter echo time is larger.

The reconstruction of an MR image from conventional PE methods, or conventional PF methods in general, usually involves a weighting of the acquired echo signals in k-space, a Fourier transform, and optionally a phase correction and subsequent elimination of the imaginary part in image space. The weighting addresses the truncation of the echo signals in k-space and suppresses the otherwise occurring (Gibbs) ringing artifacts. For example, a simple Hanning window filter may be used as a weighting, which varies smoothly from zero to one over an appropriately chosen distance in k-space.

However, the use of such a weighting has been observed to also cause signal loss in MRA, which may be misconstrued as a stenosis. Hence, according to yet another aspect, the invention proposes a method of MR imaging of an object placed in an examination volume of an MR system, which method comprises the steps of:

- subjecting the object to an imaging sequence comprising a series of RF excitations, wherein an echo signal is generated in the presence of a readout magnetic field gradient in each repetition time interval between successive RF excitations, wherein phase-encoding magnetic field gradients are switched in each repetition time interval to sample a pre-defined region of k-space;
- acquiring the echo signals from the object as partial echoes;
- applying a shift in k-space in the readout direction to the acquired echo signal data, weighting the echo signal data, and reconstructing an intermediate MR image for each of a number of different shift values; and
- computing a final MR image from the intermediate MR images by selecting, for each voxel of the final MR image, the voxel value with the maximum intensity from the set of intermediate MR images at the respective voxel position.

This aspect of the invention, which may be employed in combination with the above-described other aspects or separately thereof, is based on the insight that signal loss in PF imaging may arise from rapid variations of the phase in image space. To approximately compensate for such rapid variations of the phase in image space, the acquired echo signals are first shifted by different extents in k-space according to said number of shift values and a weighting is then applied to them. For each shift value, a separate intermediate reconstruction is then performed, and signal recovery in image space is finally attained by selecting per voxel the maximum signal intensity over all resulting intermediate MR images. The weighting suppresses ringing artifacts, but also affects the acquired echo signals. Since the phase in image space is a priori unknown, the effect of the weighting on the acquired echo signals is also unknown. Hence, the invention aims at minimizing this effect by considering a range of relative shifts between the weighting and the acquired echo signals. This is motivated by the fact that applying a shift to the acquired echo signals in k-space hardly alters the magnitude in image space if the weighting is ignored. Moreover, this is motivated by the observation that applying a weighting to the acquired echo signals in k-space mostly reduces the magnitude in image space.

The methods of the invention described thus far can be carried out by means of an MR system including at least one main magnet coil for generating an essentially uniform, static magnetic field $B_0$ within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The methods of the invention can be implemented by a corresponding programming of the reconstruction unit and/or the control unit of the MR system.

The methods of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows an MR system for carrying out the method of the invention;

Fig. 2 shows a diagram of k-space illustrating the bipolar readout strategy of the invention;

Fig. 3 shows a schematic (simplified) pulse sequence diagram according to a first embodiment of the invention;

Fig. 4 shows a schematic (simplified) pulse sequence diagram according to a second embodiment of the invention;

Fig. 5 shows a schematic (simplified) pulse sequence diagram according to a third embodiment of the invention;

Fig. 6 shows a schematic (simplified) pulse sequence diagram according to a fourth embodiment of the invention;

Fig. 7 shows MR images illustrating another aspect of a PF method according to the invention.

DETAILED DESCRIPTION OF THE EMBODIMENTS

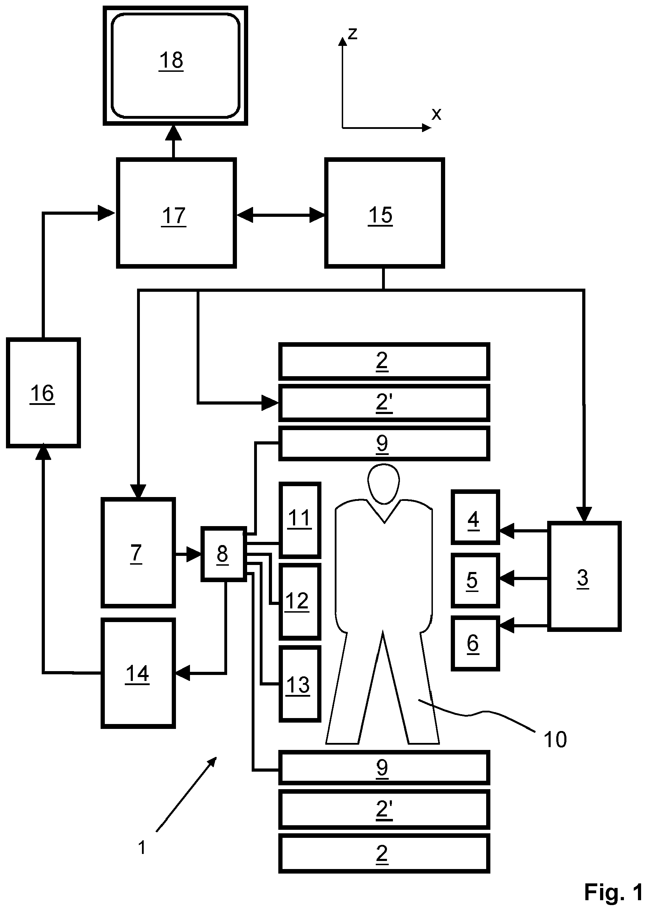

With reference to Fig. 1, an MR system 1 is shown as a block diagram. The device comprises superconducting or resistive main magnet coils 2 such that a substantially uniform, temporally constant main magnetic field $B_0$ is created along a z-axis through an examination volume. The device further comprises a set of (1st, 2nd,

and - where applicable - 3rd order) shimming coils 2', wherein the current flow through the individual shimming coils of the set 2' is controllable for the purpose of minimizing $B_0$ deviations within the examination volume.

A magnetic resonance generation and manipulation system applies a series of RF pulses and switched magnetic field gradients to invert, excite, refocus, and/or spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a RF body coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. The RF pulses are used to manipulate magnetic resonance and select a portion of a body 10 positioned in the examination volume. The MR signals are also picked up by the RF body coil 9.

For generation of MR images of limited regions of the body 10, a set of local RF array coils 11, 12, 13 are placed contiguous to the region selected for imaging. The array coils 11, 12, 13 can be used to receive MR signals induced by transmissions of the RF body coil.

The resultant MR signals are picked up by the RF body coil 9 and/or by the RF array coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives MR signal data from a single or a plurality of k-space lines in rapid succession following each RF excitation pulse. A data acquisition system 16 performs analog-to-digital conversion of the received signals and converts the MR data to a digital format suitable for further processing. In modern MR systems the data acquisition system 16 is a separate computer which is specialized in acquisition of raw image data.

Ultimately, the digital MR signal data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are arranged, by corresponding programming, to perform the method of the invention described herein above and in the following.

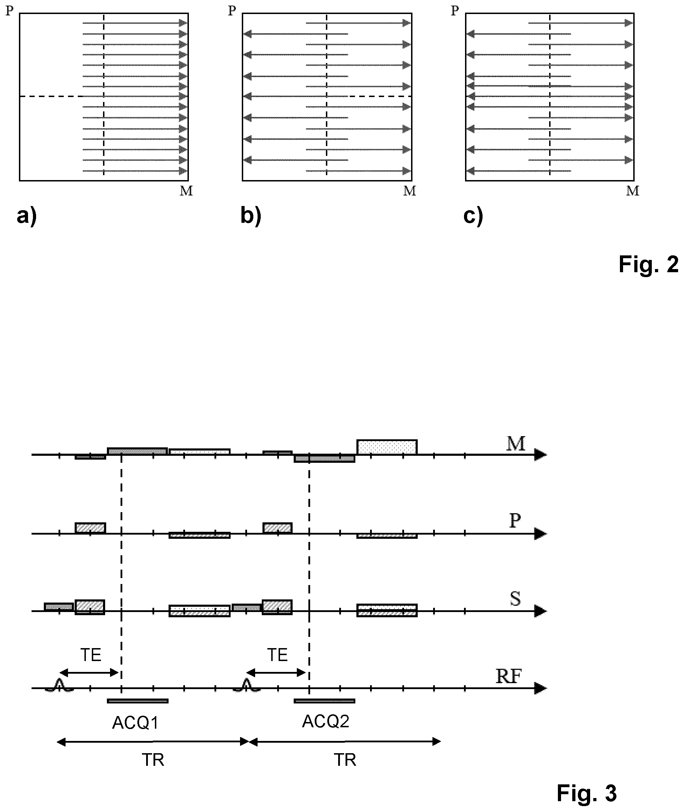

According to the invention, echo signals are acquired from the body 10 as partial echoes. Each partial echo represents a k-space line. This is illustrated in Fig. 2. In the depicted two-dimensional k-space diagrams the readout direction is indicated by M and the phase-encoding direction by P. In conventional PE acquisition (Fig. 2a), the peripheral parts of k-space are covered in one direction, but not in the opposite direction. A large continuous k-space area is thus spared. To avoid the resulting poor conditioning of the MR image reconstruction, the direction in which the partial echoes are acquired is reversed during the scan according to the invention. This allows generating the alternative sampling patterns illustrated in Figs. 2b and 2c (among others). The PE acquisition is performed with different readout polarities, each echo signal being associated with either a first direction (to the right in Fig. 2) or a second direction (to the left in Fig. 2) which is opposite to the first direction, wherein the echo signals associated with the first and the second direction sample k-space sparsely in the phase-encoding direction P. In principle, the full k-space can be covered in this way, without prolonging TE, by performing the acquisition twice with opposite readout directions. In the example of Fig. 2b, the readout direction is reversed between adjacent k-space lines, resulting in two uniformly sparsely sampled (i.e. subsampled) data sets in the phase-encoding direction P. In the example of Fig. 2c, two non-uniformly subsampled data sets in the phase-encoding direction are obtained. The k-space lines associated with the first and the second readout direction overlap in the central k-space part in the phase-encoding direction in the examples of Fig. 2b and 2c such that the central k-space part in the phase-encoding direction is fully sampled, i.e. not subsampled. This further improves the conditioning of the reconstruction. In Fig. 2c, the central k-space part in the frequency-encoding direction is also fully sampled.

A strategy to implement the sampling patterns shown in Figs. 2b and 2c efficiently is provided in Fig 3. The frequency-encoding direction is reversed after each repetition to cover k-space sequentially from bottom to top, for example.

Fig. 3 shows a pulse sequence diagram of a 3D spoiled partial gradient-echo sequence constituting an imaging sequence according to the invention. The diagram shows switched magnetic field gradients in the frequency-encoding direction M, the phase-encoding direction P, and the slice-selection direction S. Moreover, the diagram shows the RF excitation and refocusing pulses as well as the time intervals during which echo signals are acquired, designated by ACQ1 and ACQ2. One gradient echo is generated in each repetition time between successive RF excitations. The diagram covers the acquisition of the first two echo signals. In subsequent repetition times TR, the phase-encoding magnetic field gradients in the directions P and S are scaled to sample a pre-defined region of k-space. The two echo signals are generated at echo time TE. From the odd (left) to the even (right) repetitions, the polarity of the first two gradient lobes in the readout direction M is reversed, while the area of the third gradient lobe is adjusted in the even repetitions to preserve the steady-state spoiling regime. This does not necessarily lead to a longer TR, because a longer TR is often chosen anyway to optimize the signal-to-noise ratio (SNR).

In an alternative approach, the readout direction is reversed only once. The two subsampled echo signal data sets are acquired serially in this case. While this allows disrupting the steady-state spoiling regime and keeping, except for the sign, the area of the third gradient lobe in the readout direction M, the two subsampled echo signal data sets are potentially less consistent, for example in the presence of motion.

Reversing the readout direction of the partial echo signals during the scan causes the distortions induced by main magnetic field inhomogeneity to change direction. These distortions can be addressed by mapping the main magnetic field inhomogeneity in a separate measurement and by taking them into account in the reconstruction step. Alternatively, they can be estimated from the two subsampled sets of echo signals, requiring a separate intermediate reconstruction of both and the application of a registration to the resulting images.

Moreover, reversing the readout direction of the partial echo signals during the scan potentially requires considering variations in linear and higher order gradient fields. This involves mapping a spatially or spatiotemporally varying phase difference between the echo signals acquired with opposite readout direction. This phase difference can also be estimated from the two subsampled sets of echo signals.

The final reconstruction of the MR image from the acquired echo signals then solves the inverse problem corresponding to the model

$$\begin{bmatrix} \mathbf{y}_1 \\ \mathbf{y}_2 \end{bmatrix} = \begin{bmatrix} \mathbf{E}_1 \mathbf{D}_1 \mathbf{P}_1 \\ \mathbf{E}_2 \mathbf{D}_2 \mathbf{P}_2 \end{bmatrix} \mathbf{x},$$

wherein y denotes the two subsampled sets of echo signals, E denotes the corresponding encoding matrices, D denotes the corresponding distortion matrices, P denotes the corresponding phase error matrices, and x denotes the image. Since the missing data is now always surrounded by available data in k-space, the conditioning of the inverse problem is much improved.

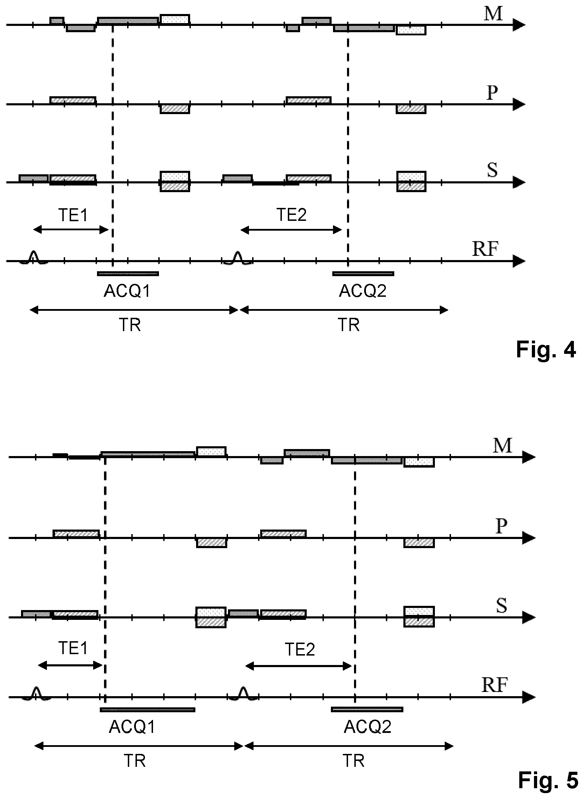

An example of dual-acquisition Dixon imaging with bipolar PE acquisition is shown in Fig. 4. The two sub-acquisitions with opposite polarities of the readout magnetic field gradient M are performed in series with different echo times TE1 and TE2 for chemical shift encoding. Depicted is one repetition from each sub-acquisition. The first (shorter) echo time TE1 is associated with the first readout gradient direction while the second (longer) echo time TE2 is associated with the second readout gradient direction. In the first repetition on the left, a dead time is introduced at the end. In the second repetition on the right, a dead time is introduced after the slab selection. For the sake of simplicity, flow compensation is applied only in the readout direction in the example.

Compared to conventional non-contrast-enhanced cerebral MRA with an opposed-phase TE, the dual-acquisition Dixon imaging sequence illustrated in Fig. 4 provides superior fat suppression and also reaches shorter TEs. However, the introduced dead times lead to a longer repetition time TR and a lower scan efficiency, defined as the ratio of the duration of the acquisition window ACQ 1 and ACQ2 and TR. To remedy this, i.e. to improve on the scan efficiency, two different strategies may be applied to the two sub-acquisitions, as illustrated in Fig. 5, which shows a serial dual-acquisition Dixon imaging sequence with individually optimized, bipolar PE acquisition. In the first repetition on the left, the readout magnetic field gradient and the acquisition window ACQ 1 are extended at the end, and the spoiler and rewinder magnetic field gradients are shifted. Moreover, the strength of the readout magnetic field gradient is reduced. This leads to a smaller PEF close to 0.5 (with the PEF indicating the fraction of k-space sampled by the PE relative to the full k-space), which is feasible in combination with the bipolar PE acquisition according to the invention, since a fully sampled central k-space is not required anymore for performing phase corrections. In the second repetition on the right, the readout magnetic field gradient and the acquisition window are extended in the front, and the phase-encoding gradients are shifted. This leads to a larger PEF. Preferably, TE1 of the first sub-acquisition is chosen more out-of-phase (with regard to the relative phase of water and fat signals) than TE2 of the second sub-acquisition. In this way, flow-induced signal loss between the first and the second sub-acquisition due to the longer TE is less likely to be misconstrued as water-fat dephasing.

The two sub-acquisitions in the above embodiments may be performed in series. Since the spoiling is disrupted once at the transition from the first to the second sub-acquisition, some additional repetition time intervals may be inserted at this transition to re-establish the spoiling. This causes only a marginal increase in scan time.

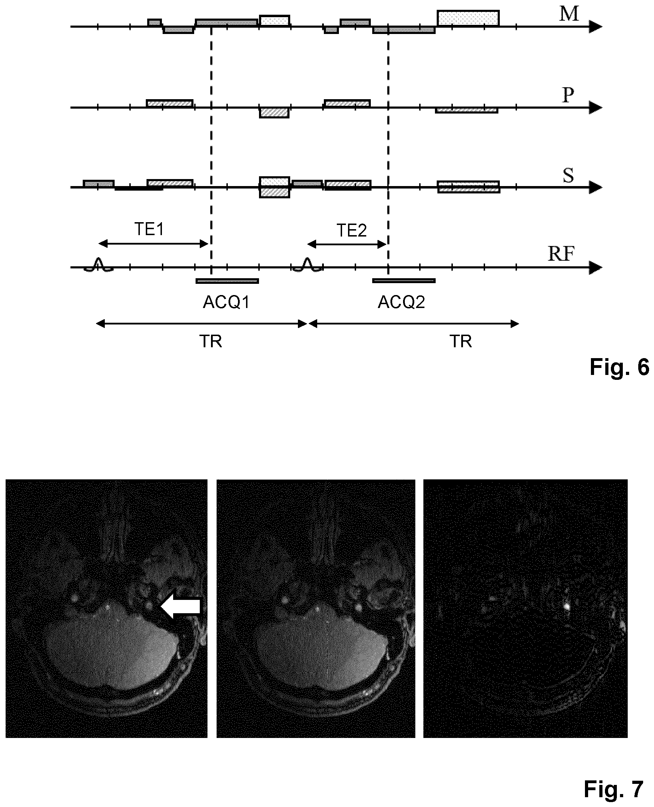

Alternatively, it may be advantageous to interleave the two sub-acquisitions, for instance by switching between them after each repetition. The integral of the magnetic field gradients in the readout direction M has to remain constant in this case, which requires the area of the spoiler magnetic field gradient in the readout direction M to be increased in one of the sub-acquisitions, as illustrated in Fig. 6, which shows an interleaved dual-acquisition Dixon imaging sequence with bipolar partial echo acquisition and optimized allocation of the two echo times TE1 and TE2 to the two polarities of the readout magnetic field gradient. Preferably, the area of the spoiler readout magnetic field gradient is increased in the sub-acquisition with the shorter echo time, in this case TE2, to optimize the scan efficiency.

Furthermore, the invention proposes to (approximately) compensate for undesirable signal loss in PF imaging arising from rapid variations of the phase in image space, which has the potential to result in misdiagnoses. The acquired echo signals are first shifted by different extents in k-space according to a number of shift values and a weighting is then applied to them. For each shift value, a separate intermediate reconstruction is then performed, and the maximum signal intensity is selected per voxel over all resulting intermediate MR images. Mathematically, the proposed PF reconstruction method may be described by

$$s(x) = max_p\{|F\{W(k)\,S(k+p)\}|\},$$

wherein S denotes the acquired echo signals, $W$ denotes the weighting, F denotes a Fourier transform, p denotes a set of shift values, and s denotes the reconstructed final MR image. This aspect of the invention is illustrated with time-of-flight (TOF) MRA in Fig. 7, in which a selected slice from a three-dimensional axial partial echo acquisition, reconstructed from the echo signals from one channel of the employed head coil, is shown, once with a conventional PE method (left image) and once with the PF method proposed by the invention (middle image), as well as their difference (right image). Using the conventional PF method with a simple weighting leads to the signal loss in the left interior carotid artery marked in the left image, which could easily be misconstrued as a stenosis. However, the PF method proposed by the invention, with a set of 20 shift values in this example, successfully recovers the signal intensity in this vessel, and it turns out that there is indeed no indication of a stenosis.

**Claims**

1. Method of MR imaging of an object (10) placed in an examination volume of an MR system (1), the method comprising the steps of:

    - subjecting the object (10) to an imaging sequence comprising a series of RF excitations, wherein an echo signal is generated in the presence of a readout magnetic field gradient in each repetition time interval between successive RF excitations, wherein phase-encoding magnetic field gradients (P, S) are switched in each repetition time interval to sample a pre-defined region of k-space;
    - acquiring the echo signals from the object (10) as partial echoes with different readout polarities, each echo signal being associated with either a first direction of the readout magnetic field gradient or a second direction of the readout magnetic field gradient which is opposite to the first direction, wherein the echo signals associated with the first and/or the second direction sample k-space sparsely in at least one phase-encoding direction (P, S); and
    - reconstructing an MR image from the acquired echo signals.

2. Method of claim 1, wherein the echo signals associated with the first direction sample a sub-region of k-space that is not sampled by the echo signals associated with the second direction, and vice versa.

3. Method of claim 1 or 2, wherein the k-space regions sampled by the echo signals associated with the first and second directions, respectively, overlap in a central part of k-space.

4. Method of any one of claims 1-3, wherein the echo signals associated with the first and second directions, respectively, sample k-space in an interleaved pattern in the at least one phase-encoding direction.

5. Method of any one of claims 1-4, wherein the echo signals associated with the first and second directions, taken in combination, sample k-space fully in a central part of k-space.

6. Method of any one of claims 1-5, wherein the reconstructing of the MR image from the acquired MR signals relies on sensitivity encoding, compressed sensing, or combinations thereof, instead of on the assumption of smooth phase variation across the MR image.

7. Method of any one of claims 1-6, further comprising the step of mapping the main magnetic field inhomogeneity, wherein the main magnetic field inhomogeneity is taken into account in the step of reconstructing the MR image.

8. Method of any one of claims 1-7, further comprising the step of mapping a spatially or spatiotemporally varying phase difference between the echo signals associated with the first and the second direction, respectively, in image space, wherein the phase difference is taken into account in the step of reconstructing the MR image.

9. Method of any one of claims 1-8, wherein a spoiler magnetic field gradient in the readout direction, applied after acquiring the echo signals, is adapted such that the integral area of the readout magnetic field gradient is the same for each repetition time interval for both the first and the second direction.

**10.** Method of any one of claims 1-9, wherein the echo signals are acquired at an echo time at which the signal contributions from water and from fat are approximately in quadrature, wherein the contributions from water and fat are separated in the step of reconstructing the MR image.

**11.** Method of any one of claims 1-9, wherein the echo signals are acquired at different echo times, each echo signal being associated with either a first echo time or a second echo time so that a chemical shift encoding is applied to the acquired echo signal, wherein contributions from water and fat are separated in the step of reconstructing the MR image.

**12.** Method of claim 11, wherein the strength of the readout magnetic field gradient applied during acquisition of the echo signals associated with the shorter echo time is smaller than the strength of the readout magnetic field gradient applied during acquisition of the echo signals associated with the longer echo time.

**13.** Method of MR imaging of an object (10) placed in an examination volume of an MR system (1), the method comprising the steps of:

- subjecting the object (10) to an imaging sequence comprising a series of RF excitations, wherein an echo signal is generated in the presence of a readout magnetic field gradient in each repetition time interval between successive RF excitations, wherein phase-encoding magnetic field gradients (P, S) are switched in each repetition time interval to sample a pre-defined region of k-space;
- acquiring the echo signals from the object (10) as partial echoes;
- applying a shift in k-space in the readout direction to the acquired echo signal data, weighting the echo signal data, and reconstructing an intermediate MR image for each of a number of different shift values; and
- computing a final MR image from the intermediate MR images by selecting, for each voxel of the final MR image, the voxel value with the maximum intensity from the set of intermediate MR images at the respective voxel position.

**14.** MR system comprising at least one main magnet coil (2) for generating a uniform, static magnetic field $B_0$ within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR system (1) is configured to perform the steps of the method of any one of claims 1-14.

**15.** Computer program comprising instructions which, when the program is executed by a computer, preferably by a control unit (15) and/or a reconstruction unit (17) of an MR system (1), cause the computer to carry out the method of any one of claims 1-14.

EP 4 261 557 A1

Fig. 1

Fig. 2

Fig. 3

Fig. 4

Fig. 5

Fig. 6

Fig. 7

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

**Application Number**

**EP 22 16 8641**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BYDDER MARK ET AL: "Minimizing echo and repetition times in magnetic resonance imaging using a double half-echo k-space acquisition and low-rank reconstruction", NMR IN BIOMEDICINE., vol. 34, no. 4, 9 December 2020 (2020-12-09), pages 1-8, XP055886032, GB ISSN: 0952-3480, DOI: 10.1002/nbm.4458 * page 2 – page 4; figures 2, 4 * ----- | 1-12,14, 15 | INV. G01R33/48 G01R33/54 G01R33/561 ADD. G01R33/44 G01R33/485 G01R33/565 |

**TECHNICAL FIELDS SEARCHED (IPC)**

G01R

### INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

**see sheet C**

| Place of search | Date of completion of the search | Examiner |
|---|---|---|
| Munich | 15 November 2022 | Raguin, Guy |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................

& : member of the same patent family, corresponding
    document

EPO FORM 1503 03.82 (P04E07)

Europäisches
Patentamt
European
Patent Office
Office européen
des brevets

**INCOMPLETE SEARCH
SHEET C**

```
Claim(s) completely searchable:
       1-12

Claim(s) searched incompletely:
       14, 15

Claim(s) not searched:
       13

Reason for the limitation of the search:

1.       Pursuant to Rule 62a(1) EPC the Applicant was invited to select
which independent claims to search amongst the two independent method
claims (1, 13).

The Applicant requested in the letter of 26-10-2022 that "the search
[...] be carried out on the basis of the independent Claim 1 and the
dependent Claims 2 to 12, as well as the Claims 13 and 14 in as far as
they refer to any one of the Claims 1 to 12".

However, since independent method claim 13 does not refer back to any
other claim, it is assumed that the applicant meant to refer to claims 14
and 15 instead of "claims 13 and 14", and to consider them as referring
back to "any one of the Claims 1 to 12" instead of "the method of any one
of claims 1-14" as presently recited in claims 14 and 15.

2.       Consequently, claim 13 is excluded from the search, and
accordingly, claims 14 and 15 are limited to referring back to "the
method of any one of claims 1-12".
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. BYDDER et al.** *NMR in Biomedicine,* 2021, vol. 34, e4458

- **M. B. SCHEIDEGGER et al.** *Magnetic Resonance Imaging,* 1991, vol. 9, 517-524